# EUROPÄISCHE PATENTANMELDUNG

(11) **EP 3 964 608 A1**
(43) Veröffentlichungstag der Anmeldung: **09.03.2022**
(21) Anmeldenummer: 20194097.0
(22) Anmeldetag: 02.09.2020
(51) Int. Cl.: C25B 13/04, C23C 16/455, C25B 13/05, H01M 50/403, C25B 9/19

(54) **DIREKTE BESCHICHTUNG EINER MEMBRAN MIT EINEM KATALYSATOR**

(71) Anmelder: Siemens Aktiengesellschaft, 80333 München (DE)
(72) Erfinder: Jensen, Jens Dahl, 14050 Berlin (DE); Krüger, Ursus, 14089 Berlin (DE); Winkler, Gabriele, 13587 Berlin (DE)

(57) **Zusammenfassung**

Die vorliegende Erfindung betrifft ein Verfahren zum Beschichten einer Membran mit einem Katalysator, eine dadurch hergestellte Membran, eine Elektrolysezelle umfassend die Membran sowie die entsprechende Verwendung der Membran, und eine Vorrichtung, die zur Durchführung des Verfahrens geeignet ist.

## Beschreibung

Die vorliegende Erfindung betrifft ein Verfahren zum Beschichten einer Membran mit einem Katalysator, eine dadurch hergestellte Membran, eine Elektrolysezelle umfassend die Membran sowie die entsprechende Verwendung der Membran, und eine Vorrichtung, die zur Durchführung des Verfahrens geeignet ist.

### Stand der Technik

Der hierin beschriebene Stand der Technik basiert auf dem den Erfindern bekannten Wissen und stellt nicht unbedingt den aus der Literatur bekannten Stand der Technik dar, sodass sich in der nachfolgenden Beschreibung des Stands der Technik auch Passagen befinden können, die nicht nur der zitierten Literatur entnommen werden können, sondern auch auf Weiterentwicklungen der Erfinder basieren können und somit nicht zwangsläufig allgemeinen Stand der Technik darstellen.

Die Umwandlung und die Speicherung von Energien aus erneuerbaren Quellen wie Wind, Wasser und Sonne über längere Zeiträume erfolgt unter anderem in sogenannten Power-to-Gas-Anlagen. In diesen Anlagen wird der aus Wind, Sonne oder Wasserkraft gewonnene Ökostrom durch elektrochemische Zersetzung des Wassers (Elektrolyse) in Wasserstoff umgewandelt. Wasserstoff ist ein Energieträger, der im Gegensatz zu fossilen Brennstoffen bei der Verbrennung keine schädlichen Kohlendioxid-Emissionen verursacht. Außerdem lässt sich der Wasserstoff in die bestehende Erdgas-Infrastruktur auf einfache Weise einspeisen.

Dabei wird der Wasserstoff in der Power-to-Gas-Anlage unter anderem über eine trockene Polymer-Elektrolyt-Membran- Elektrolyse (PEM-Elektrolyse) erzeugt. Die PEM-Elektrolyse besteht aus einer Wasserstoffentwicklungsreaktion (Hydrogen Evolution Reaction, HER) an der Kathode und einer Sauerstoffentwicklungsreaktion (Oxygen Evolution Reaction, OER) an der Anode.

Zur Gewinnung von reinem Wasserstoff an der Kathode werden die HER- und die OER-Reaktion räumlich durch eine Membran, gewöhnlich eine Protonenaustauschmembran (Proton Exchange Membran), üblicherweise aus Nafion, voneinander getrennt. Diese Membran ist durch ihre spezielle chemische Struktur für Protonen (H-Atome) durchlässig und für Gase sowie Elektrolyte undurchlässig.

Da die HER- und OER- Reaktionen kinetisch sehr träge sind, erfordern diese Reaktionen wirksame Elektrokatalysatoren. Die Katalysatoren reduzieren den Energiebedarf für die Wasserspaltung und steigern die Spaltungsrate. Die wirksamsten Elektrokatalysatoren sind die Metalle aus der Platingruppe (Ru, Rh, Pd, Os, Ir, Pt) und ihre Oxide.

Zurzeit werden entweder kommerziell erhältliche Iridium-Katalysatoren, z. B. IrO₂/TiO₂ der Firma Umicore (IrO₂ geträgert auf TiO₂), Ir-black der Firma Alfa Aesar, oder einfach IrO₂ den Firmen Alfa Aesar und Sigma Aldrich verwendet, oder Antimon-Zinnoxid-Partikel (ATO-Partikel (Antimon Tin Oxide)), die mit IrO₂ durch Reduktion eines anorganischen Vorläufers/Precursors, wie Iridium-(III)-Chlorid mit dem Reduktionsmittel Natriumborhydrid (NaBH₄) in wasserfreiem Ethanol unter Beimischung von Inertgas, oder Dihydrogenhexachloroiridat(IV)-Hydrat (H₂IrCl₆ x H₂O) mit dem Reduktionsmittel Ethylenglykol, bei einem pH-Wert von 11 in destilliertem Wasser unter Schutzgas, Ultraschall und Erhitzen beschichtet. Die Katalysatorpartikel werden üblicherweise mit 2-Propanol, destilliertem Wasser und einer ca. 15 bis 20%-igen Nafion-Ionomer-Lösung - als Bindemittel und zum Ladungstransport an die Stromkollektoren - zu einer Tinte verarbeitet. Dann wird die Tinte entweder direkt durch ein Spritz- oder Rakelverfahren oder indirekt über das Decal-Verfahren über eine Transferfolie auf die Polymer-Membran aufgetragen.

Die Elemente der Platingruppe sind in der Erdkruste sehr selten vorhanden und dementsprechend teuer für eine zunehmende Skalierbarkeit in den Prozessen der Energieumwandlung. Daher wäre es vorteilhaft, wenn die Elektrokatalysatoren über ein spezielles Beschichtungsverfahren punktuell direkt auf die Membran in sehr geringer Schichtdicke, z.B. einige Nanometer, aufgetragen werden. Durch das spezielle Beschichtungsverfahren soll die eingesetzte Menge an Platingruppen-Elementen minimiert und ihre katalytische Reaktivität verbessert werden.

### Zusammenfassung der Erfindung

Die Erfinder haben gefunden, dass eine Reduzierung der Katalysatormenge auf einer Membran, wobei der Katalysator eine Metallverbindung sein kann, durch direkte Beschichtung der Membran, beispielsweise einer Proton Exchange- oder Polymeraustausch-Membran erreicht werden kann, indem eine Abscheidung des Katalysators aus der Dampfphase über einen Precursor und eine anschließende Schichtbildung durch Anwendung eines Plasmas erfolgt. Die Reduzierung der Katalysatormenge wird hierbei nicht durch Vergrößerung der aktiven Fläche erreicht, sondern durch die Art und Weise des Abscheidungsverfahrens. Mit dieser Technik können wohl bis zu 99.3 Gew.% der Katalysatormenge gegenüber den herkömmlichen Auftragsverfahren mit der Tintenspritztechnik oder einem Decal-Verfahren eingespart werden bei gleich großer aktiver Fläche.

Ein erster Aspekt der vorliegenden Erfindung betrifft ein Verfahren zum Beschichten einer Membran mit einem Katalysator, umfassend
a) Bereitstellen einer Membran in einem Reaktorraum;
b) Beschichten der Membran auf mindestens einer ersten Oberfläche mit mindestens einem Metall und/oder mindestens einer Metallverbindung durch Atomlagenabscheidung, wobei das mindestens eine Metall und/oder die mindestens eine Metallverbindung in den Reaktorraum geleitet und mittels Atomlagenabscheidung auf der mindestens einen Oberfläche der Membran beschichtet wird;
c) Spülen des Reaktorraums derart, dass im Reaktorraum verbleibendes und nicht auf der mindestens einen Oberfläche der Membran abgeschiedenes Metall und/oder im Reaktorraum verbleibende und nicht auf der mindestens einen Oberfläche der Membran abgeschiedene Metallverbindung aus dem Reaktorraum entfernt wird;
d) Erzeugen eines Plasmas mittels einer Plasmaquelle innerhalb des Reaktorraums und in Kontakt bringen des Plasmas mit dem mindestens einen auf der mindestens einen Oberfläche der Membran abgeschiedenen Metall und/oder der mindestens einen auf der mindestens einen Oberfläche der Membran abgeschiedenen Metallverbindung, wobei das Plasma mit dem mindestens einen Metall und/oder der mindestens einen Metallverbindung reagiert; und
e) Spülen des Reaktorraums derart, dass im Schritt d) bei der Reaktion erzeugte volatile Verbindungen entfernt werden.

Weiterhin betrifft die Erfindung eine beschichtete Membran, die durch das Verfahren hergestellt wird, eine Elektrolysezelle umfassend die beschichtete Membran, und die Verwendung der beschichteten Membran in einer Elektrolysezelle.

Zudem ist eine Vorrichtung zur Beschichtung einer Membran offenbart, umfassend:
- einen Reaktor umfassend einen Reaktorraum;
- einen Substrathalter im Reaktorraum, der dazu ausgebildet ist, eine Membran zu halten;
- eine Plasmaquelle, die innerhalb des Reaktorraums angeordnet und dazu ausgebildet ist, aus einem Reaktionsgas ein Plasma zumindest in Teilen innerhalb des Reaktorraums zu erzeugen;
- eine erste Zuführeinrichtung für mindestens ein Metall und/oder mindestens eine Metallverbindung, die dazu ausgebildet ist, dem Reaktorraum mindestens ein Metall und/oder mindestens eine Metallverbindung zuzuführen;
- eine zweite Zuführeinrichtung für das Reaktionsgas, die dazu ausgebildet ist, das Reaktionsgas dem Reaktorraum derart zuzuführen, dass mit der Plasmaquelle, insbesondere mit Hilfe eines Generators bzw. Plasmagenerators, aus dem Reaktionsgas ein Plasma erzeugt werden kann; und
- mindestens eine dritte Zuführeinrichtung für ein Spülgas, die dazu ausgebildet ist, dem Reaktorraum mindestens ein Spülgas zuzuführen, wobei die mindestens eine zweite Zuführeinrichtung auch teilweise mit der ersten und/oder zweiten Zuführeinrichtung kombiniert sein kann.

Weitere Aspekte der vorliegenden Erfindung sind den abhängigen Ansprüchen und der detaillierten Beschreibung zu entnehmen.

### Beschreibung der Figuren

Die beiliegenden Zeichnungen sollen Ausführungsformen der vorliegenden Erfindung veranschaulichen und ein weiteres Verständnis dieser vermitteln. Im Zusammenhang mit der Beschreibung dienen sie der Erklärung von Konzepten und Prinzipien der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander dargestellt. Gleiche, funktionsgleiche und gleich wirkende Elemente, Merkmale und Komponenten sind in den Figuren der Zeichnungen, sofern nichts anderes ausgeführt ist, jeweils mit denselben Bezugszeichen versehen.

Figur 1 zeigt schematisch ein beispielhaftes erfindungsgemäßes Verfahren.

In Figuren 2 und 3 sind schematisch beispielhafte erfindungsgemäße beschichtete Membranen dargestellt, und Figur 4 ist schematisch eine beispielhafte Elektrolysezelle zu entnehmen, in der die erfindungsgemäße beschichtete Membran Anwendung findet.

Figur 5 zeigt schematisch eine beispielhafte erfindungsgemäße Vorrichtung, mit der eine Membran beschichtet werden kann.

Figur 6 ist ein Pulsmuster einer DC-Spannung mit einer überlagerten Pulsspannung zu entnehmen, und Figur 7 ein Pulsmuster einer Umpolung eines Gitters oder einer Lochplatte und eines Substrathalters in schneller Folge in einem erfindungsgemäßen Beispiel.

Figur 8 zeigt beispielhaft mögliche Taktzeiten eines Abscheidungszyklus in einem Beispiel der Erfindung.

Figur 9 stellt schematisch den Protonen-Transport durch eine Protonenaustauschmembran mit strukturiert abgeschiedener Katalysatorschicht in einem Beispiel der vorliegenden Erfindung dar, und Figur 10 den Protonen-Transport durch eine dicke Partikel-Polymerschicht in einem Vergleichsbeispiel des Stands der Technik.

### Detaillierte Beschreibung der Erfindung

### Definitionen

So nicht anderweitig definiert haben hierin verwendete technische und wissenschaftliche Ausdrücke dieselbe Bedeutung, wie sie von einem Fachmann auf dem Fachgebiet der Erfindung gemeinhin verstanden wird.

Eine Membran ist im Rahmen der vorliegenden Erfindung eine biaxial gespannte Fläche mindestens eines Materials, die die Fähigkeit zur Abtrennung hat und eine selektive Durchlässigkeit für verschiedene Substanzen besitzt, beispielsweise Gase, Flüssigkeiten und/oder Ionen. Die Dicke der Membran ist hierbei nicht besonders beschränkt und kann beispielsweise eine Dicke sein, wie sie in Elektrolysezellen zur Anwendung kommt, beispielsweise von 1,0 bis 10.000,0 µm. Eine Membran weist hierbei Poren auf, welche die selektive Durchlässigkeit bedingen, beispielsweise durch das Vorhandensein funktioneller Gruppen im Material der Membran, sodass sich beispielsweise eine selektive Durchlässigkeit für Kationen oder Anionen ergeben kann. Das Material der Membran ist nicht besonders beschränkt, umfasst jedoch gemäß bevorzugten Ausführungsformen jedoch zumindest ein Polymer. Bevorzugt ist die Membran eine polymerbasierte Membran, welche in Elektrolysezellen zur Anwendung kommen kann, insbesondere eine Kationen- oder Anionen -selektive Membran, beispielsweise eine protonenselektive Membran, insbesondere eine Polymer-Elektrolyt-Membran (PEM). Gemäß bestimmten Ausführungsformen ist die Membran eine Polymeraustausch-Membran ist. Bevorzugt ist eine Membran auf Basis von Nafion oder Aquivion gemäß bestimmten Ausführungsformen. In einem Wasserstoff-produzierenden Elektrolyseur als Anwendung der hergestellten Membran stellt die bevorzugte Polymeraustausch-Membran einen Festelektrolyten dar. Der Festelektrolyt besteht aus einem hydrophoben Fluor-Kohlenstoffgerüst, ähnlich dem Teflon (PTFE), und aus CF₂-Seitenketten, die an ihren Kettenenden Sulfonsäure-Gruppen tragen. Diese Sulfonsäure-Gruppen verleihen den Seitenketten einen hydrophilen Charakter und sind für den eigentlichen Protonentransport zuständig. Diese auf perfluorierter Sulfonsäure basierende Kationenleiter sind unter dem Nafion oder Aquivion bekannt. Daher wird die bevorzugte Protonenaustauschmembran im Rahmen der Erfindung auch Nafion-Membran genannt.

Als Plasma ein im Rahmen der Erfindung ein Teilchengemisch auf atomar-molekularer Ebene zu verstehen, dessen Bestandteile teilweise geladene Komponenten, Ionen und Elektronen sind, wobei auch Radikale vorhanden sind. Insofern kann das vorliegende Verfahren auch als PEALD-Verfahren (plasma-enhanced atomic layer deposition) und/oder als REALD-Verfahren (radical-enhanced atomic layer deposition) verstanden werden, wobei eine Bildung von Radikalen jedoch bevorzugt zu großen Teilen vermieden wird, insbesondere bei Beschichtung von Membranen auf Polymerbasis. Gemäß bestimmten Ausführungsformen erfolgt also in Schritten b) bis e) des erfindungsgemäßen Verfahrens ein PEALD-Verfahren und kein REALD-Verfahren.

In der Anmeldung beziehen sich Mengenangaben auf Gew.%, soweit es nicht anderweitig angegeben oder aus dem Zusammenhang ersichtlich ist.

Der Normaldruck ist 101325 Pa = 1,01325 bar.

Ein erster Aspekt der Erfindung betrifft ein Verfahren zum Beschichten einer Membran mit einem Katalysator, umfassend
a) Bereitstellen einer Membran in einem Reaktorraum;
b) Beschichten der Membran auf mindestens einer ersten Oberfläche mit mindestens einem Metall und/oder mindestens einer Metallverbindung durch Atomlagenabscheidung, wobei das mindestens eine Metall und/oder die mindestens eine Metallverbindung in den Reaktorraum geleitet und mittels Atomlagenabscheidung auf der mindestens einen Oberfläche der Membran beschichtet wird;
c) Spülen des Reaktorraums derart, dass im Reaktorraum verbleibendes und nicht auf der mindestens einen Oberfläche der Membran abgeschiedenes Metall und/oder im Reaktorraum verbleibende und nicht auf der mindestens einen Oberfläche der Membran abgeschiedene Metallverbindung aus dem Reaktorraum entfernt wird;
d) Erzeugen eines Plasmas mittels einer Plasmaquelle innerhalb des Reaktorraums und in Kontakt bringen des Plasmas mit dem mindestens einen auf der mindestens einen Oberfläche der Membran abgeschiedenen Metall und/oder der mindestens einen auf der mindestens einen Oberfläche der Membran abgeschiedenen Metallverbindung, wobei das Plasma mit dem mindestens einen Metall und/oder der mindestens einen Metallverbindung reagiert; und
e) Spülen des Reaktorraums derart, dass im Schritt d) bei der Reaktion erzeugte volatile Verbindungen entfernt werden.

Im erfindungsgemäßen Verfahren werden die Schritte a) bis e) in dieser Reihenfolge ausgeführt, also a), b), c), d), e).

Im Verfahren ist Schritt a) nicht besonders beschränkt. Die Membran kann auf geeignete Weise im Reaktorraum bereitgestellt werden. Beispielsweise kann sie auf einen Substrathalter im Reaktorraum angebracht werden bzw. angebracht sein.

Gemäß bestimmten Ausführungsformen wird im Reaktorraum nach Schritt a) ein Vakuum angebracht, um Gase aus dem Reaktorraum zu entfernen. Das Vakuum ist hierbei nicht besonders beschränkt und kann beispielsweise in einem Bereich von 10⁻⁶ bis 10 mbar, beispielsweise 10⁻⁵ bis 10⁻² mbar, z.B. ca. 10⁻³ mbar liegen. Ein solches Vakuum kann erfindungsgemäß auch nach Schritt b) und/oder c) und/oder d) und ggf. nach Schritt e) angelegt werden, um verbleibendes Metall und/oder verbleibende Metallverbindung, das bzw. die nicht abgeschieden wurde, das Spülgas und/oder verbleibendes Plasma bzw. verbleibendes Gas der Plasmabildung sowie Reaktionsprodukte bei der Reaktion mit dem Plasma zu entfernen. Gemäß bestimmten Ausführungsformen wird zumindest nach Schritt c) zudem ein Vakuum angebracht, das wie das Vakuum nach Schritt a) ausgelegt sein kann. Das Anlegen des Vakuums kann beispielsweise über eine geeignete Vakuumpumpe erfolgen, welche mit dem Reaktorraum, beispielsweise über ein Ventil, verbunden sein kann.

Auch der Schritt b) des Beschichtens der Membran auf mindestens einer ersten Oberfläche mit mindestens einem Metall und/oder mindestens einer Metallverbindung durch Atomlagenabscheidung, wobei das mindestens eine Metall und/oder die mindestens eine Metallverbindung in den Reaktorraum geleitet und mittels Atomlagenabscheidung auf der mindestens einen Oberfläche der Membran beschichtet wird, ist nicht besonders beschränkt. Hierzu kann das mindestens eine Metall und/oder die mindestens eine Metallverbindung geeignet eingebracht und dann mit der mindestens einen ersten Oberfläche der Membran kontaktiert werden, und hierdurch beschichtet werden. Die Atomlagenabscheidung (atomic layer deposition, ALD), ist nicht besonders beschränkt und kann auf übliche Weise erfolgen.

Erfindungsgemäß können mehr als ein Metall und/oder eine Metallverbindung eingebracht werden, beispielsweise um später gemischte Katalysatoren herzustellen, wobei dies auch in getrennten Schritten erfolgen kann, zwischen denen dann ein Spülen des Reaktorraums mit einem Spülgas, das nicht besonders beschränkt ist und bevorzugt ein inertes Gas wie Stickstoff und/oder Argon ist, stattfinden kann. Gemäß bestimmten Ausführungsformen wird mindestens eine Metallverbindung, bevorzugt eine Metallverbindung, welche einen Vorläufer für das Metall darstellen kann, beschichtet.

Im Verfahren wie dann auch in der beschichteten Membran ist das Metall bzw. das Metall der Metallverbindung nicht besonders beschränkt. Bevorzugt ist das Metall derart, dass es nach der Plasmabehandlung in Schritt d) eine katalytisch aktive Spezies bildet, insbesondere für eine Elektrolyse. Gemäß bestimmten Ausführungsformen umfasst das mindestens eine Metall oder die mindestens eine Metallverbindung ein Metall umfasst, das ausgewählt ist aus der Gruppe, bestehend aus Ru, Rh, Pd, Ag, Os, Ir, Pt, Au, insbesondere Ru, Rh, Pd, Os, Ir, Pt, bevorzugt Ir und/oder Pt. Aus diesen Metallen können im erfindungsgemäßen Verfahren bevorzugte Katalysatoren auf der Oberfläche der Membran gebildet werden. Als Katalysator wird gemäß bestimmten Ausführungsformen ein Metalloxid aus der Platin-Gruppe gewählt. Von den Metalloxiden aus der Platin-Gruppe zeigen IrO₂ und RuO₂ die geringste Überspannung beim Übergang von einer niedrigen in eine höhere Oxidationsstufe und damit die höchste Aktivität für eine Sauerstoffentwicklungsreaktion (OER). Einerseits reicht die Adsorption der sauerstoffhaltigen Zwischenstufen für einen zügigen Ladungsdurchtritt aus, und andererseits adsorbieren diese Zwischenstufen nicht so stark, so dass der Sauerstoff nach weiteren Reaktionen freigesetzt wird. RuO₂ korrodiert während der Sauerstoffentwicklung im sauren Milieu unter Bildung von RuO₄ oder H₂RuO₅. Iridiumdioxid ist im sauren Milieu wesentlich stabiler und zeigt trotzdem noch eine ausreichende Aktivität zur Sauerstoffentwicklung. Aus diesem Grund wird gemäß bestimmten, bevorzugten Ausführungsformen, mit dem erfindungsgemäßen Verfahren eine erste Oberfläche der Membran, insbesondere einer Protonenaustauschmembran (Proton Exchange Membran), die insbesondere in einer Elektrolysezelle der Anodenseite in einem PEM-Elektrolyseur zugewandt ist, mit Iridiumdioxid beschichtet. Durch ein physikalisch-chemisches Syntheseverfahren, z.B. Plasmaunterstützte Atomlagenabscheidung (PEALD) kann also auf der Oberfläche einer Membran, insbesondere einer Polymeraustausch-Membran, erfindungsgemäß eine katalytisch wirkende Metalloxid-Schicht erzeugt werden.

Gemäß bestimmten Ausführungsformen erfolgt der Schritt b) bei einer Temperatur von weniger als 300°C, bevorzugt von weniger als 250°C, weiter bevorzugt von weniger als 200°C, noch weiter bevorzugt von weniger als 150°C, insbesondere von weniger als 100°C. Hierdurch wird eine Beeinträchtigung der Membran, insbesondere bei Verwendung einer polymerbasierten Membran, vermieden.

Hierfür ist es bevorzugt, geeignete Metallverbindungen zu beschichten, welche sich bei diesen Temperaturen beschichten lassen, also geeignete Vorläufer zu beschichten, welche bei diesen Temperaturen im Gaszustand sind oder sich zumindest bei einer solchen Temperatur leicht zerstäuben lassen oder bei einer geringfügig höheren Temperatur, beispielsweise bis zu 500°C, verdampfen lassen und dann bei entsprechend niedriger Temperatur nach Abkühlung beim Einbringen in den Reaktorraum abgeschieden werden können.

Als Metallverbindungen eignen sich beispielsweise für die bevorzugten Metalle Ir und Pt die folgenden Vorläufer bzw. Precursoren:
Iridium (III) acetylacetonato 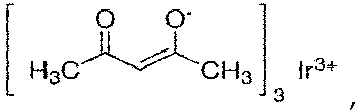 1,5-Cyclooctadien(acetylacetonato)iridium(I) 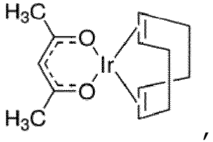 1,5-Cyclooctadien(hexafluoroacetylacetonato)iridium(I) 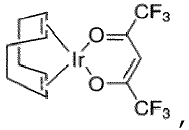 1-Ethylcyclopentadienyl-1,3-cyclohexadien-iridium(I)

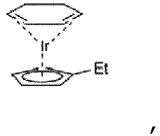

### (Methylcyclopentadienyl)(1,5-cyclooctadien) iridium(I)

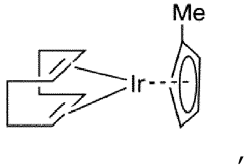

Tris(norbornadien)(acetylacetonato)iridium (III), Trimethyl (methylcyclopentadienyl)platin (IV) (MeCpPtMe₃)

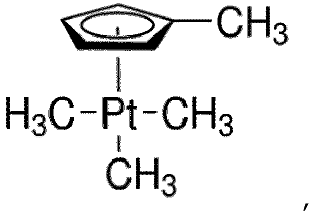

Platin(II)acetylacetonat

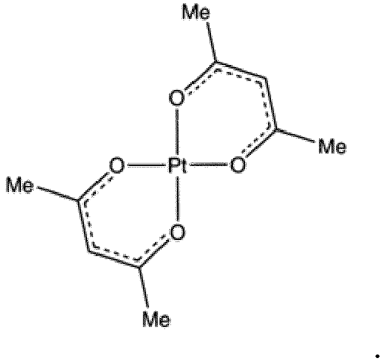

Gemäß bestimmten Ausführungsformen, wenn die Membran eine Nafion-Membran ist, wird als Precursor für Platin bevorzugt MeCpPtMe₃, für Iridium bevorzugt Iridium(III)acetylacetonat, Ir(acac)3 verwendet, da Nafion einen Schmelzpunkt von 200°C hat und bei 100°C die Ionenleitfähigkeit verloren gehen kann.

Gemäß bestimmten Ausführungsformen wird im Schritt b) des Beschichtens das mindestens eine Metall und/oder die mindestens eine Metallverbindung und/oder ein Vorläufer des mindestens einen Metalls mittels eines inerten Trägergases in den Reaktorraum geleitet. Das Trägergas ist hierbei nicht besonders beschränkt, ist bevorzugt jedoch inert, beispielsweise N₂ und/oder ein Edelgas wie He, Ne, Ar, Kr, und/oder Mischungen davon.

Ebenso ist Schritt c) des Spülens des Reaktorraums derart, dass im Reaktorraum verbleibendes und nicht auf der mindestens einen Oberfläche der Membran abgeschiedenes Metall und/oder im Reaktorraum verbleibende und nicht auf der mindestens einen Oberfläche der Membran abgeschiedene Metallverbindung aus dem Reaktorraum entfernt wird, nicht besonders beschränkt, und kann beispielsweise mit einem geeigneten Spülgas erfolgen. Das Spülgas ist hierbei nicht besonders beschränkt, ist bevorzugt jedoch inert, beispielsweise N₂ und/oder ein Edelgas wie He, Ne, Ar, Kr, und/oder Mischungen davon. Beispielsweise kann das Spülgas auch aus derselben Quelle wie das Trägergas zugeführt werden, also dem Trägergas entsprechen.

Die Erzeugung eines Plasmas mittels einer Plasmaquelle in Schritt d) ist ebenfalls nicht besonders beschränkt und kann auf geeignete Weise erfolgen. Hierfür kann ein geeigneter Generator bzw. Plasmagenerator im Reaktorraum und/oder außerhalb vorgesehen werden, mit dem das Plasma durch Zufuhr von Leistung in Form von Spannung und Strom gezündet werden kann, wobei jedoch eine andere Form der Plasmaerzeugung bzw. Bereitstellen einer Plasmaquelle, also einer Quelle für ein Plasma, nicht ausgeschlossen ist.

Gemäß bestimmten Ausführungsformen wird das Plasma in Schritt d) mittels eines Hohlkathoden-Plasmaquelle erzeugt. Die Anwendung einer Hohlkathode-Plasmaquelle wird bevorzugt, weil die Hohlkathode aufgrund Ihrer Gestalt in Ihrem Hohlräumen Sauerstoff-Ionen und Elektronen einschließen kann und so für eine höhere Plasmadichte (Elektronendichte) sorgt. Des Weiteren fällt üblicherweise nach der Plasma-Zündung die Spannung ab, aber eine weitere Zunahme der Stromstärke erzeugt keine größere Steigung der Spannung. Dagegen steigt bei kapazitiv oder induktiv gekoppelten Plasma-Quellen die Spannung mit dem Strom kontinuierlich an. Dieses hohe Spannungspotential - fast höher als die angewandte Spannung - beschleunigt die Ionen, die einen so hohen Energieüberschuss erhalten, dass die Substratoberfläche geschädigt wird. Bei der Hohlkathode bleibt das Plasmapotential niedrig, so dass die Ionen weniger Energie aufnehmen und die Substratoberfläche, also die Membran, nicht schädigen.

Auch das in Kontakt bringen bzw. Zusammenführen des Plasmas mit dem mindestens einen auf der mindestens einen Oberfläche der Membran abgeschiedenen Metall und/oder der mindestens einen auf der mindestens einen Oberfläche der Membran abgeschiedenen Metallverbindung, wobei das Plasma mit dem mindestens einen Metall und/oder der mindestens einen Metallverbindung reagiert, ist nicht besonders beschränkt. Hierbei kann durch geeignete Anordnung von Plasmaquelle und Substrathalter bzw. Membran eine Beschädigung der Membran verhindert werden, wobei hier der Abstand geeignet beispielsweise von der Anordnung der Membran, der Geometrie der Plasmaquelle, der Zündspannung, der Dauer der Plasmaerzeugung, etc. abhängen kann. Die Reaktion erfolgt beim Verfahren zumindest zwischen der Beschichtung der Membran und dem Plasma, sodass sich aus dem abgeschiedenen Metall und/oder Metallverbindung eine katalytisch aktive Metallspezies bildet, beispielsweise ein Oxid bei Verwendung eines Sauerstoffplasmas. Beim vorliegenden Verfahren ist hierbei von Vorteil, dass der Katalysator gezielt auf der Oberfläche der Membran gebildet werden kann, insbesondere da das Plasma auch schwer in Poren der Membran eindringen kann. Hierdurch kann zum einen gut ein Verstopfen der Poren oder eine anderweitige Modifikation, welche den Transport durch die Poren der Membran stört, verhindert werden, zum anderen erfolgt die Bereitstellung des Katalysators an der Stelle, wo er erforderlich ist. Bei bisherigen Verfahren mit Tinten kann es zu Verstopfung von Poren kommen, und der Katalysator kann auch teilweise in die Poren eindringen, was im Vergleich zum vorliegenden Verfahren zu Effizienzverlusten, beispielsweise bei einer Elektrolyse, führen kann.

Das Gas zur Plasmaerzeugung ist nicht besonders beschränkt und kann abhängig von einem zu erzeugenden Katalysator ausgewählt werden, umfasst jedoch gemäß bestimmten Ausführungsformen zumindest Sauerstoff. Gemäß bestimmten Ausführungsformen erfolgt in Schritt d) die Plasmaerzeugung mit einem Gas umfassend Sauerstoff, wobei bei der Reaktion eine Sauerstoffverbindung des mindestens einen Metalls und/oder der mindestens einen Metallverbindung hergestellt wird. Bevorzugt wird das Plasma mit Sauerstoff als Plasma erzeugt. Mit Sauerstoff können effektive Metalloxide als Katalysator hergestellt werden. Zudem ist das Sauerstoffplasma gut kontrollierbar.

Gemäß bestimmten Ausführungsformen ist in Schritt d) zwischen der Plasmaquelle und der beschichteten Membran ein Gitter oder eine Lochplatte, bevorzugt aus Metall, angeordnet. Durch das - hier maskierende - Gitter oder die Lochplatte kann eine Strukturierung der Reaktion auf der Membran, beispielsweise einer Nafion-Membran, erreicht werden. Das Gitter oder die Lochplatte befindet sich hierbei horizontal zwischen Substrathalter und Plasmaquelle, bevorzugt im Wesentlichen parallel oder parallel zur Membranoberfläche. Dabei ist das Gitter oder die Lochplatte gemäß bestimmten Ausführungsformen in Richtung Membran in der Höhe verstellbar, so dass der Abstand des Gitters oder der Lochplatte zum Substrat variiert werden kann.

Das Gitter ist hierbei nicht besonders beschränkt. Es kann eine geeignete Geometrie mit Löchern aufweisen, welche nicht besonders beschränkt ist. Das Gitter deckt gemäß bestimmten Ausführungsformen zumindest die Fläche der Membran ab, wobei jedoch, wie beschrieben, zwischen Gitter und Membran ein geeigneter Abstand vorgesehen ist. Dieser kann beispielsweise abhängig von einer zu erzielenden Strukturierung, der Stärke des Plasmas, etc. variiert werden. Die Löcher des Gitters können dabei rund, eckig, quadratisch, etc. sein. Die Lochgröße des Gitters sowie die Stegbreite zwischen den Löchern und die Dicke des Gitters sind nicht besonders beschränkt. Die Lochgröße des Gitters kann beispielsweise bis zu 1 mm betragen, z.B. 10 µm bis 1 mm betragen, und/oder die Stegbreite zwischen den Löchern kann zwischen 10 und 100 µm, z.B. 60 µm betragen. Die Größe der Löcher kann beispielsweise im Hinblick auf eine gewünschte Katalysatorfläche angepasst werden, und/oder auch im Hinblick auf eine spätere Kontaktierung, beispielsweise bei Verwendung der beschichteten Membran in einer Elektrolysezelle. Beispielsweise erhält man bei einer Membranfläche von 56,5 cm² eine aktive Oberfläche von 50 cm² bei einer Stegbreite von 60 µm und einer Lochgröße von 1 mm.

Ebenso ist die Lochplatte nicht besonders beschränkt, und kann entsprechend des Gitters ausgebildet sein, wobei sich bei der Lochplatte jedoch entsprechende andere Geometrien ergeben können.

Gemäß bestimmten Ausführungsformen wird bzw. ist an einen Substrathalter, auf dem die Membran befestigt ist, und dem Gitter oder der Lochplatte ein Gleichspannungsgenerator angeschlossen, wobei das Gitter oder die Lochplatte an einem negativen Pol des Gleichspannungsgenerators angeschlossen wird. Der Gleichspannungsgenerator ist hierbei nicht besonders beschränkt. Mit dem negativen Gitter oder der negativen Lochplatte können Ionen des Plasmas an Stellen der Stege des Gitters oder abseits der Löcher der Lochplatte davon abgehalten werden, zur Oberfläche der beschichteten Membran zu kommen, sodass sie entsprechend dort nicht reagieren.

Gemäß bestimmten Ausführungsformen wird während des Schritts d) an den Gleichspannungsgenerator über eine Grundspannung eine überlagerte Pulsspannung angelegt, derart, dass an dem Gitter oder der Lochplatte wechselnd eine positive und eine negative Spannung anliegt. Gemäß bestimmten Ausführungsformen weist die überlagerte Spannung eine Pulsfrequenz von 0,5 bis 100 kHz, bevorzugt 1 bis 25 KHz auf.

Der Hohlkathoden-Effekt (niedriges Plasmapotential, hohe Plasmadichte, wie oben beschrieben) und das maskierende Gitter oder die Lochplatte, das oder die mit dem Substrathalter an einem pulsfähigen Gleichspannungsgenerator und Mittelfrequenzgenerator angeschlossen ist, können zur Abscheidung einer strukturierten kristallinen Katalysatorschicht, beispielsweise einer Iridiumdioxid-Schicht bei Verwendung von Ir als Metall, auf der Oberfläche der Membran, beispielsweise einer Nafion-Oberfläche durch Steuerung der Bewegung der Ionen im Plasma, beispielsweise einer O-Atom- und O-Ionenbewegung, führen, sodass hier Strukturen gebildet werden, welche an die Verwendung später angepasst sein können, beispielsweise hinsichtlich Elektrodenkontakten bei Verwendung in einer Elektrolysezelle.

An das Gitter oder die Lochplatte und den Substrathalter kann also über Stromzuführungen ein Gleichspannungsgenerator angeschlossen werden. Der Gleichspannungsgenerator erzeugt gemäß bestimmten Ausführungsformen in kurzen Abständen eine zur Grundspannung überlagerte Pulsspannung mit einer bevorzugten Frequenz von 1 bis 25 KHz innerhalb der Taktzeit von beispielweise 5s eines Plasmagenerators (z.B. umfassend eine Hohlkathode), um eine gepulste Umpolung von maskierenden Gitter oder der Lochplatte und Substrathalter zu ermöglichen. Das Gitter oder die Lochplatte wird gemäß bestimmten Ausführungsformen an den negativen Pol und der Substrathalter an den positiven Pol des Spannungsgenerators angeschlossen. Die negativ geladenen Ionen des Plasmas, z.B. Sauerstoff-Ionen, werden von dem positiven Substrathalter angezogen und strömen durch die Öffnungen des Gitters oder der Lochplatte zur Membranoberfläche, z.B. einer Nafion-Oberfläche, die mit Metall oder Metallverbindung bzw. Metallprecursor, z.B. Ir-Precursoren, besetzt ist. Ionen und Atome des Plasmas, z.B. O-Ionen und O-Atome, die auf die Stege des Gitters oder abseits der Löcher der Lochplatte treffen, werden an dieser Stelle vom negativ geladenen Gitter oder der negativ geladenen Lochplatte zurückgestoßen, so dass diese Ionen und Atome mit der Beschichtung der Membran wie auch der Membranoberfläche nicht reagieren. Die Grundspannung zwischen Gitter oder Lochplatte und Substrathalter kann von einer gepulsten Spannung überlagert werden, um die Anziehungseffekte am Substrathalter und die Abstoßungseffekte an den Gitterstegen oder entsprechenden Stellen der Lochplatte zu verstärken.

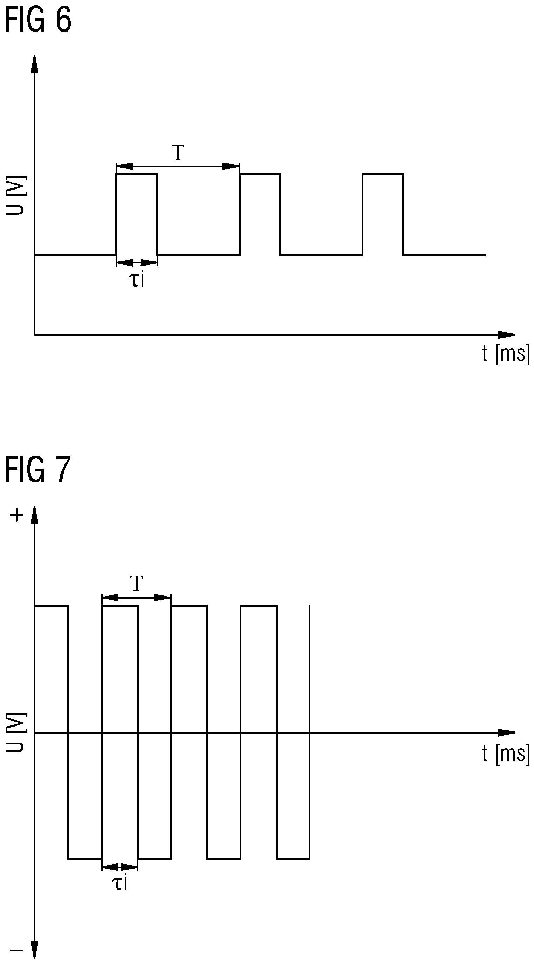

Durch eine kurze Umpolung des Pulses wird das Gitter oder die Lochplatte positiv und die Konzentration von Ionen und Atomen am Gitter oder Lochplatte für kurze Zeit erhöht. Wird die Umpolung von Gitter oder Lochplatte und Substrathalter aufgehoben, stellt sich der ursprüngliche Zustand wieder ein. Die Atome und die Ionen strömen durch die Gitterlöcher oder Löcher der Lochplatte zum positiv geladenen Substrathalter auf die beschichtete Oberfläche der Membran. An den negativ geladenen Gitterstegen oder entsprechenden Plattenstellen der Lochplatte werden die Ionen und Atome, z.B. O-Ionen und O-Atome, wieder in die Plasmawolke zurückgestoßen und stehen für weitere Kollusionen zur Verfügung. Erfolgt die Umpolung in sehr kurzen Zeitabständen von beispielsweise 10 Mikrosekunden bis 5 Millisekunden, z.B. 40 Mikrosekunden bis eine Millisekunde, kann ein gerichteter Strahl aus Ionen und Atomen, der am Gitterloch oder Loch der Lochplatte gebündelt wird, auf die mit Metall und/oder Metallverbindung bzw. Precursor-Molekülen belegte Membranoberfläche gebildet werden. Für Taktzeiten von beispielsweise 40 Mikro- bis einer Millisekunde können beispielsweise Mittelfrequenzgeneratoren (entspricht 1 bis 25 KHz) an das Gitter oder die Lochplatte und den Substrathalter angeschlossen werden. Mit der überlagerten Pulsspannung oder der Umpolung in kürzeren Zeitabständen, insbesondere kleiner als eine Millisekunde, wird die Beweglichkeit der Atome und Ionen des Plasmas erhöht. Die energiereichen Atome und Ionen des Plasmas geben ihren Impuls beim Auftreffen an die adsorbierten bzw. beschichteten Precursor-Moleküle auf der Membran weiter und erhöhen deren Mobilität vorübergehend. Durch diesen Energieeintrag kommt es zu einer Erwärmung auf der Substratoberfläche. Diese genannten Effekte können die Bildung von dichten faserförmigen Strukturen mit glatter Oberfläche bewirken. Figur 6 und Figur 7 zeigen schematisch mögliche Pulsmuster für eine Grundspannung mit überlagerter Pulsspannung (Figur6) und für eine Umpolung der Grundspannung (Figur7). Figur 6 zeigt beispielhaft ein Pulsmuster einer DC-Spannung mit einer überlagerten Pulsspannung, wobei T: Periodendauer; 1/T: Frequenz f; τi: Impulsdauer;
Betriebszyklus: τi/(T- τi)^{∗}100%; t: Zeit; U: Spannung ist. Figur 7 zeigt ein beispielhaftes Pulsmuster einer Umpolung von maskierendem Gitter oder Lochplatte und Substrathalter in schneller Folge von 1 bis 25 KHz (Mittelfrequenzspannung).

Der Schritt e) des Spülens des Reaktorraums derart, dass im Schritt d) bei der Reaktion erzeugte volatile Verbindungen entfernt werden, ist ebenfalls nicht besonders beschränkt. Als Spülgas kann dasselbe Spülgas wie in Schritt c) verwendet werden, oder aber auch ein davon verschiedenes. Gemäß bestimmten Ausführungsformen wird dasselbe Spülgas verwendet. Durch den Schritt e) werden unerwünschte Reaktionsprodukte, beispielsweise durch Reaktion der Membran mit dem Plasma, aus dem Reaktionsraum entfernt, sodass diese nicht nachfolgend als Verunreinigungen verbleiben. Es werden also beispielsweise volatile CO₂- und/oder H₂O-Moleküle entfernt, beispielsweise durch Spülen mit Stickstoff, wobei nicht ausgeschlossen ist, dass daneben noch andere Moleküle, Atome und/oder Ionen, beispielsweise verbleibend vom Plasma, entfernt werden.

Nach Schritt e) kann ggf. die beschichtete Membran mit der reagierten Beschichtung dem Reaktorraum entnommen und ihrer weiteren Bestimmung zugeführt werden, beispielsweise also in einer Elektrolysezelle verwendet werden.

Gemäß bestimmten Ausführungsformen werden die Schritte b) bis e) mehrfach hintereinander durchgeführt. Hierdurch kann beispielsweise eine vollständige Belegung der Membranoberfläche bewirkt werden. Auch können komplexere Katalysatorstrukturen auf der Oberfläche gestaltet werden, wie etwa Nanonadeln, etc. Gemäß bestimmten Ausführungsformen finden keine Zwischenschritte zwischen den Schritten b) bis e) statt.

Gemäß bestimmten Ausführungsformen wird ein erfindungsgemäßes Verfahren auch beiden - gegenüberliegenden - Seiten einer Membran durchgeführt, wobei sich das mindestens eine Metall und/oder die mindestens eine Metallverbindung, welche auf einer Oberfläche der Membran abgeschieden wird, von einem zweiten mindestens einen Metall und/oder einer zweiten mindestens einen Metallverbindung auf einer gegenüberliegenden Oberfläche der Membran unterscheiden kann oder nicht und sich bevorzugt unterscheidet. Bei einem Unterschied des mindestens einen Metalls und/oder der mindestens einen Metallverbindung können auf den gegenüberliegenden Seiten der Membran unterschiedliche Katalysatoren erzeugt werden, welche beispielsweise in einer Elektrolysezelle unterschiedliche Reaktionen auf Kathodenseite und Anodenseite katalysieren können.

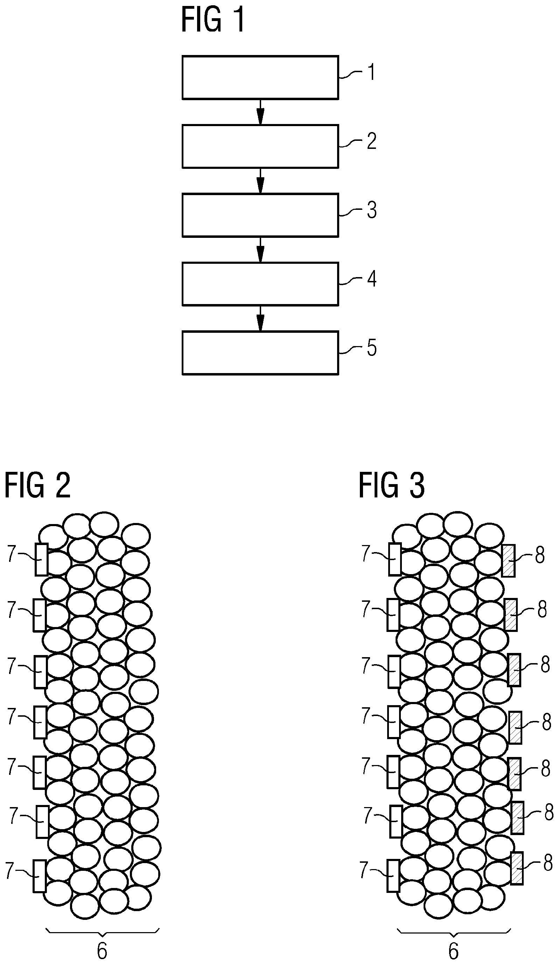

Ein erfindungsgemäßes Verfahren ist schematisch in Figur 1 gezeigt. An den Schritt 1 des Bereitstellens einer Membran in einem Reaktorraum schließt sich Schritt 2 des Beschichtens der Membran auf mindestens einer ersten Oberfläche mit mindestens einem Metall und/oder mindestens einer Metallverbindung durch Atomlagenabscheidung an, gefolgt von Schritt 3 des Spülens des Reaktorraums derart, dass im Reaktorraum verbleibendes und nicht auf der mindestens einen Oberfläche der Membran abgeschiedenes Metall und/oder im Reaktorraum verbleibende und nicht auf der mindestens einen Oberfläche der Membran abgeschiedene Metallverbindung aus dem Reaktorraum entfernt wird. Im Anschluss schließt sich Schritt 4 des Erzeugens eines Plasmas mittels einer Plasmaquelle innerhalb des Reaktorraums und des in Kontakt bringen des Plasmas mit dem mindestens einen auf der mindestens einen Oberfläche der Membran abgeschiedenen Metall und/oder der mindestens einen auf der mindestens einen Oberfläche der Membran abgeschiedenen Metallverbindung, wobei das Plasma mit dem mindestens einen Metall und/oder der mindestens einen Metallverbindung reagiert, an, sowie daran der Schritt 5 des Spülens des Reaktorraums derart, dass im Schritt d) bei der Reaktion erzeugte volatile Verbindungen entfernt werden.

Ein weiterer Aspekt der vorliegenden Erfindung betrifft eine beschichtete Membran, die durch das erfindungsgemäße Verfahren hergestellt ist. Durch das erfindungsgemäße Verfahren lässt sich eine sehr dünne und zielgerichtete, ggf. auch strukturiere Membran herstellen.

Gemäß bestimmten Ausführungsformen ist die Membran eine polymerbasierte Membran, beispielsweise eine Nafion-Membran. Die Beschichtung umfasst gemäß bestimmten Ausführungsformen auf einer oder zwei Oberflächenseiten der Membran gemäß bestimmten Ausführungsformen jeweils einen Metall-basierten Katalysator, der nicht beschränkt ist, beispielsweise auf einer Seite basierend auf Ir und auf der anderen Seite auf Pt.

Figur 2 zeigt schematisch eine beispielhafte Membran 6, z.B. eine Nafion-Membran, auf der strukturiert ein erster Katalysator 7 durch das erfindungsgemäße Beschichtungsverfahren hergestellt wurde, und Figur 3 eine beispielhafte schematische Darstellung einer Membran 6, z.B. einer Nafion-Membran, die auf der einen Seite mit einem ersten Katalysator 7, z.B. einem Katalysator zur Sauerstoffentwicklung (OER-Katalysator, oxygen evolution reaction Katalysator), z.B. Iridiumdioxid, und auf der anderen Seite mit einem zweiten Katalysator 8, z.B. einem Katalysator zur Wasserstoffentwicklung (HER-Katalysator, hydrogen evolution reaction Katalysator), z.B. Platin, beschichtet ist.

Zudem offenbart ist eine Elektrolysezelle, welche eine erfindungsgemäße beschichtete Membran umfasst. Insbesondere wird in einer solchen Elektrolysezelle die beschichtete Membran zum Trennen eines Kathodenraums umfassend eine Kathode und eines Anodenraums umfassend eine Anode verwendet, wobei es auch möglich ist, dass die Beschichtung der Membran an der Kathode und/oder Anode anliegt.

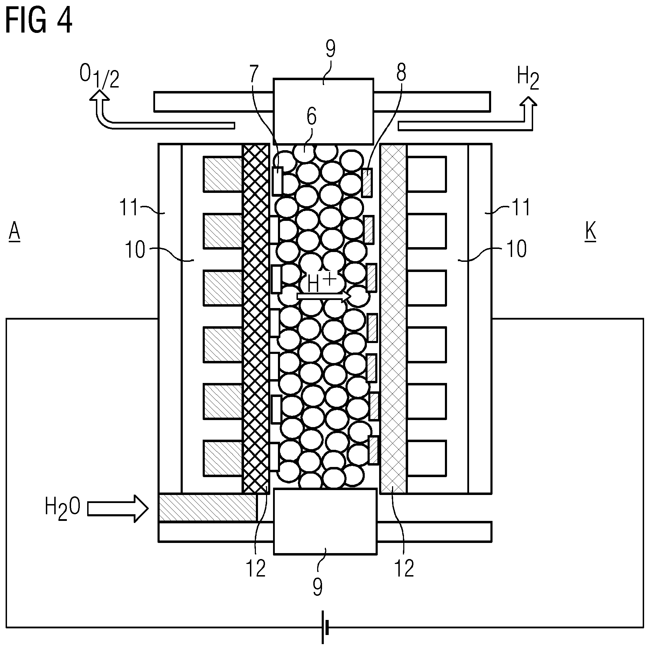

Eine beispielhafte Elektrolysezelle ist in Figur 4 schematisch gezeigt. An der Membran 6 mit einem ersten Katalysator 7, z.B. Iridiumdioxid, und einem zweiten Katalysator 8, z.B. Platin, liegen jeweils an der Beschichtung Gasdiffusionsschichten 12, und die Membran ist nach oben und unten durch eine austauschbare weitere Membran 9 abgedichtet. Über Bipolarplatten 10 wird der elektrische Kontakt zu Endplatten 11 hergestellt, wobei die Seite mit Iridiumdioxid hier die Anode A und die Seite mit Platin die Kathode K bildet, die entsprechend an eine Stromquelle angeschlossen sind. Die Bipolarplatten 10 und Endplatten 11 bilden also Stromkollektoren, über die die Stromzufuhr erfolgt. Wird nunmehr Wasser in diese beispielhafte PEM-Zelle geleitet, entsteht auf Anodenseite Sauerstoff und auf Kathodenseite Wasserstoff. Die Membran 6 wird also hier beispielhaft in einer Elektrolysezelle, oder auch in einem Polymer-Elektrolyse-Stack zwischen den Stromkollektoren oder auch Gasdiffusionsschichten 12 als beispielsweise Protonen-durchlässige Polymermembran befestigt, wobei die Membran 6 mit ihrer strukturiert beschichteten Oberfläche eng an den Stromkollektoren anliegen kann und innerhalb des Stacks über z.B. einen Kassettenverschluss leicht austauschbar sein kann.

Da in dieser beispielhaften Elektrolysezelle der Katalysator, z.B. Iridiumdioxid, direkt über ein physikalisch-chemisches Verfahren auf die Membran-Oberfläche, z.B. Nafion-Oberfläche, strukturiert abgeschieden wird, entfällt die Herstellung einer Katalysator-Tinte, die üblicherweise aus den Katalysatorpartikeln, 2-Propanol, destilliertem Wasser und einer 15 bis 20%-igen Nafion-Ionomer-Lösung besteht, sowie die Auftragung der Tinte auf die Membran entweder über ein Sprühverfahren oder indirekt über ein Decal-Verfahren mit Hilfe einer Transferfolie. Entsprechend lassen sich die teuren Katalysatormaterialien, wie beispielsweise Iridiumdioxid als OER-Katalysator, aber auch beispielsweise die teuren und seltenen HER-Katalysatoren, z. B. Platin, sich auf diese Art und Weise mit dem erfindungsgemäßen Verfahren in sehr geringen Mengen abscheiden. Entsprechend zeigt Figur 4 insbesondere gemäß bestimmten Ausführungsformen schematisch eine Darstellung einer Protonenaustauschmembran in einer Elektrolysezelle bzw. Elektrolysezelleneinheit eines Elektrolysezellenstacks mit direkter OER- und HER-Katalysator-Beschichtung.

Ein weiterer Aspekt der vorliegenden Erfindung betrifft die Verwendung einer erfindungsgemäßen beschichteten Membran in einer Elektrolysezelle. Bevorzugt ist die Verwendung in einer PEM Elektrolyse, bei der die Membran eine Polymer-Elektrolyt-Membran (PEM) ist, wobei auf einer Seite der Membran ein OER-Katalysator, z.B. Iridiumdioxid, vorgesehen ist, und optional auf einer zweiten Seite der Membran ein HER-Katalysator, z.B. Platin.

Noch ein weiterer Aspekt der vorliegenden Erfindung ist auf eine Vorrichtung zur Beschichtung einer Membran gerichtet, umfassend:
- einen Reaktor umfassend einen Reaktorraum;
- einen Substrathalter im Reaktorraum, der dazu ausgebildet ist, eine Membran zu halten;
- eine Plasmaquelle, die innerhalb des Reaktorraums angeordnet und dazu ausgebildet ist, aus eine Reaktionsgas ein Plasma zumindest in Teilen innerhalb des Reaktorraums zu erzeugen;
- eine erste Zuführeinrichtung für mindestens ein Metall und/oder mindestens eine Metallverbindung, die dazu ausgebildet ist, dem Reaktorraum mindestens ein Metall und/oder mindestens eine Metallverbindung zuzuführen;
- eine zweite Zuführeinrichtung für das Reaktionsgas, die dazu ausgebildet ist, das Reaktionsgas dem Reaktorraum derart zuzuführen, dass mit der Plasmaquelle aus dem Reaktionsgas ein Plasma erzeugt werden kann; und
- mindestens eine dritte Zuführeinrichtung für ein Spülgas, die dazu ausgebildet ist, dem Reaktorraum mindestens ein Spülgas zuzuführen, wobei die mindestens eine zweite Zuführeinrichtung auch teilweise mit der ersten und/oder zweiten Zuführeinrichtung kombiniert sein kann.

Mit der erfindungsgemäßen Vorrichtung kann insbesondere das erfindungsgemäße Verfahren durchgeführt werden. Einzelne Ausführungsformen des erfindungsgemäßen Verfahrens können entsprechend auch auf die Vorrichtung übertragen werden und finden entsprechend Anwendung.

In der erfindungsgemäßen Vorrichtung ist der eine Reaktor umfassend einen Reaktorraum nicht besonders beschränkt. Insbesondere lässt sich an den Reaktorraum ein Vakuum anlegen, entsprechend ist der Reaktor gemäß bevorzugten Ausführungsformen derart ausgestaltet, dass ein Vakuum angelegt werden kann. Hierzu kann beispielswiese eine Vakuumrichtung an den Reaktor angebracht sein, umfassend eine Vakuumpumpe und eine Vakuum-Absperrvorrichtung wie ein Ventil, mit der ein Vakuum nach Bedarf angelegt werden kann. Das Vakuum kann wie oben beschrieben ausgestaltet sein, sodass bevorzugt eine Vakuumpumpe vorgesehen sein kann, die ein Vakuum in einem Bereich von 10⁻⁶ bis 10 mbar, beispielsweise 10⁻⁵ bis 10⁻² mbar, z.B. ca. 10⁻³ mbar, erzeugen kann.

Ebenfalls ist der Substrathalter im Reaktorraum nicht besonders beschränkt. Insbesondere ist er dazu ausgebildet, eine Polymer-basierte Membran zu halten, weist also eine entsprechende Grundfläche und Rigidität auf, oder weist entsprechende Halterungen zum Einspannen der Membran auf. Der Substrathalter kann elektrisch geerdet sein.

Zudem sind die Plasmaquelle, mit deren Hilfe das Plasma entsteht, und auch ein entsprechender Plasmagenerator, der entsprechend gemäß bestimmten Ausführungsformen vorgesehen sein kann und mit dem die Zufuhr einer Leistung in Form von Spannung und Strom zur Zündung des Plasmas erreicht wird, nicht besonders beschränkt. Gemäß bestimmten Ausführungsformen ist die Plasmaquelle eine Hohlkathoden-Plasmaquelle, wobei hier im Reaktor dann gemäß bestimmten Ausführungsformen eine Hohlkathode zur Zündung des Plasmas vorgesehen sein kann. Zur Erzeugung des Plasmas können hierzu entsprechende Einrichtungen angeschlossen sein, wie eine Anpassungseinheit (Matching Unit) und ein geeigneter Signalgenerator, z.B. ein RF Generator.

Auch die erste Zuführeinrichtung für mindestens ein Metall und/oder mindestens eine Metallverbindung, die dazu ausgebildet ist, dem Reaktorraum mindestens ein Metall und/oder mindestens eine Metallverbindung zuzuführen, ist nicht besonders beschränkt. Beispielsweise kann sie eine Quelle für das mindestens eine Metall und/oder die mindestens eine Quelle umfassen, die das mindestens eine Metall und/oder die mindestens eine Metallverbindung bereitstellt. Zur Bereitstellung kann zudem eine Heizeinrichtung, z.B. ein Thermostat, vorgesehen sein, die das mindestens eine Metall und/oder die mindestens eine Metallverbindung derart erhitzt, dass sie dem Reaktorraum als Gas, Dampf, etc. derart zugeführt wird, dass eine Atomlagenabscheidung durchgeführt werden kann. Zudem kann eine Quelle für ein Trägergas vorgesehen sein, welche das mindestens eine Metall und/oder die mindestens eine Metallverbindung mit in den Reaktor führt. In der ersten Zuführeinrichtung kann zudem gemäß bestimmten Ausführungsformen ein Massenflussregler vorgesehen sein, um den Massenfluss des mindestens einen Metalls und/oder der mindestens einen Metallverbindung gezielt für eine Atomlagenabscheidung einzustellen. Zum Stoppen des Flusses des mindestens einen Metalls und/oder der mindestens einen Metallverbindung kann bei der Quelle des mindestens einen Metalls und/oder der mindestens einen Metallverbindung und/oder der Quelle des Trägergases eine entsprechende erste und/oder zweite Absperrvorrichtung vorgesehen sein, z.B. jeweils ein Ventil, die dazu ausgebildet ist, den Massenfluss des mindestens einen Metalls und/oder der mindestens einen Metallverbindung und/oder des Trägergases zu unterbrechen, z.B. bei einem Spülen oder Reagieren mit Plasma, wobei auch alternativ eine gemeinsame Absperrvorrichtung für beide vorgesehen sein kann oder auch eine Absperrvorrichtung zum Reaktorraum. Ggf. kann der Zufluss des mindestens einen Metalls und/oder der mindestens einen Metallverbindung auch über die Heizrate mit der Heizeinrichtung gesteuert werden.

Weiterhin ist auch die zweite Zuführeinrichtung für das Reaktionsgas, die dazu ausgebildet ist, das Reaktionsgas dem Reaktorraum derart zuzuführen, dass mit der Plasmaquelle aus dem Reaktionsgas ein Plasma erzeugt werden kann, nicht besonders beschränkt, sofern sie das Reaktionsgas derart zur Plasmaquelle führt, dass ein Plasma erzeugt werden kann. Sie kann eine geeignete Quelle für das Reaktionsgas, z.B. eine Quelle für Sauerstoff, und einen Massenflussregler umfassen, um gezielt ein Plasma in einem derartigen Ausmaß zu erzeugen, dass es zu einer Oberfläche der Membran reichen kann, wenn diese im Substrathalter gehalten wird. In der zweiten Zuführeinrichtung kann zudem eine dritte Absperrvorrichtung vorgesehen sein, die dazu ausgebildet ist, den Zufluss an Reaktionsgas zu stoppen, beispielsweise bei der Atomlagenabscheidung und beim Spülen.

Die mindestens eine dritte Zuführeinrichtung für ein Spülgas, die dazu ausgebildet ist, dem Reaktorraum mindestens ein Spülgas zuzuführen, wobei die mindestens eine zweite Zuführeinrichtung auch teilweise mit der ersten und/oder zweiten Zuführeinrichtung kombiniert sein kann, ist ebenfalls nicht besonders beschränkt. Beispielsweise kann als Spülgas auch das Trägergas für das mindestens eine Metall und/oder die mindestens eine Metallverbindung verwendet werden, sodass hier die Quelle des Trägergases der Quelle des Spülgases entspricht, und die erste Zuführeinrichtung teilweise mit der dritten Zuführeinrichtung kombiniert ist. Entsprechend kann auch oder alternativ die Quelle für das Reaktionsgas mit einer Quelle für Spülgas kombiniert sein, beispielsweise wenn ein Plasma aus einem Reaktionsgas und einem weiteren Gas, z.B. dem Spülgas gebildet wird, wobei dann ein Zufluss des Spülgases nach Beendigung der Plasmaerzeugung einfach beibehalten werden kann. Hier wäre dann die zweite Zuführeinrichtung teilweise mit der dritten Zuführeinrichtung kombiniert, insbesondere wenn das Spülgas ein Edelgas wie Argon ist.

Die erfindungsgemäße Vorrichtung kann zudem eine Schleuse im Reaktor umfassen, über die die Membran in den Reaktorraum eingebracht und die beschichtete Membran ausgebracht werden kann. Bei einer beidseitigen Beschichtung einer Membran kann diese im Reaktor gedreht werden, sodass hier ggf. eine entsprechende geeignete Greifeinrichtung zum Drehen und/oder auch zum Platzieren der Membran vorgesehen sein kann.

Die erfindungsgemäße Vorrichtung kann zudem ein Gitter oder eine Lochplatte umfassen, welches bzw. welche zwischen der Plasmaquelle und dem Substrathalter angeordnet ist. Gemäß bestimmten Ausführungsformen ist an den Substrathalter, auf dem die Membran befestigt werden kann, und das Gitter oder die Lochplatte ein Gleichspannungsgenerator angeschlossen, wobei das Gitter oder die Lochplatte bevorzugt an einem negativen Pol des Gleichspannungsgenerators angeschlossen ist. Bevorzugt ist der Gleichspannungsgenerator derart ausgestaltet, dass über eine Grundspannung eine gepulste Spannung angelegt werden kann. Hierzu kann beispielsweise ein Mittelfrequenzgenerator angeschlossen werden, beispielsweise mit einer Pulsfrequenz von 0,5 bis 100 kHz, bevorzugt 1 bis 25 KHz.

Eine beispielhafte erfindungsgemäße Vorrichtung wird beispielhaft in Verbindung mit Beispiel 1 nachfolgend beschrieben.

Die obigen Ausführungsformen, Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmalen der Erfindung. Insbesondere wird der Fachmann auch Einzelaspekte als Verbesserungen oder Ergänzungen zu der jeweiligen Grundform der vorliegenden Erfindung hinzufügen.

Die Erfindung wird im Anschluss mit Bezug auf verschiedene Beispiele davon weiter im Detail erläutert. Die Erfindung ist jedoch nicht auf diese Beispiele beschränkt.

### Beispiele

### Beispiel 1: Abscheidung von Iridiumdioxid

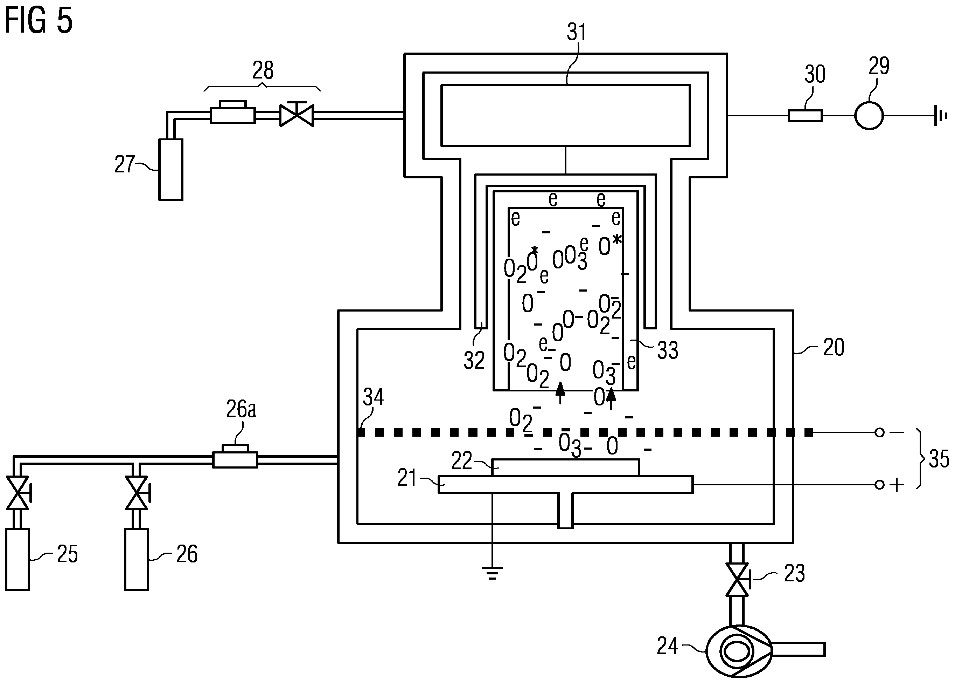

In einem ersten Beispiel wird Iridiumdioxid als Katalysator auf eine Nafion-Membran als Protonenaustauschmembran abgeschieden. Die direkte Abscheidung von Iridiumdioxid auf die Nafion- Membran kann in einer Anordnung gemäß Figur 5 erfolgen.

Die zu beschichtende Membran 22 wird über eine Schleuse (nicht gezeigt) auf den Substrathalter 21 des Reaktors 20 transportiert. Dieser kann, wie hier gezeigt, geerdet sein. Im Reaktor 20 wird über eine Turbopumpe 24 als Vakuumpumpe ein Feinvakuum von ca. 10⁻³ mbar erzeugt, wobei ein Ventil 23 vorgesehen ist, um das Vakuum entsprechend abzustellen, wenn z.B. die Plasmaerzeugung erfolgt.

Der Ir-Precursor, zum Bespiel Iridium(III)acetylacetonat, Ir(acac)3, wird einerseits in einer Quelle für Ir-Precursor 26, hier als Absorptionsgefäß (Bubbler) ausgebildet, als Schutz gegen Luftsauerstoff und Luftfeuchtigkeit aufbewahrt, und andererseits über einem Thermostaten (nicht gezeigt) in Abhängigkeit von seinem Dampfdruck erhitzt. Die Quelle für Ir-Precursor 26 (bzw. allgemein für einen Metallprecursor) ist mit einem Zuleitungsrohr und einem Entnahmerohr ausgestattet. Über das Zuleitungsrohr gelangt der Ir-Precursor mit einem Trägergas, hier Stickstoff, aus der Quelle für Trägergas 25, in eine gemeinsame Zuleitung, hier mit Massenflussregler 26a, und vermischt sich dort mit dem Ir-Precursor-Dampf. Das Stickstoff-Precursor-Dampf- Gemisch verlässt über das Entnahmerohr den Massenflussregler 26a und wird über Rohre pneumatisch mit Hilfe von Ventilen in den Reaktor geleitet. Der Ir-Precursor-Strom in den Reaktor 20 wird durch den Dampfdruck des Precursors und den geregelten Durchfluss des N₂-Trägergases so kontrolliert und gesteuert, dass eine Monolage Ir-Precursor auf die Oberfläche der Membran 22 chemisorbiert wird.

In einem zweiten Schritt werden nach dieser Absorption und schließen der Ventile der Quellen 25 und 26 überschüssige Ir-Precursor-Gasmoleküle entfernt und der Reaktor 20 mit Stickstoff gespült, beispielsweise wieder aus der Quelle für Trägergas 25, welches hier als Spülgas dient. Danach wird das Spülgas wieder geschlossen.

In einem dritten Schritt wird Sauerstoff als beispielhaftes Plasmagas aus der Quelle für Plasmagas 27 gezielt über den zweiten Massenflussregler 28, hier ebenfalls mit Ventil, in eine Hohlkathoden-Plasmaquelle 31 mit Hohlkathode 32 eingeleitet. In dieser Hohlkathoden-Plasmaquelle 31 wird zwischen Anode und Kathode eine hohe Spannung, z.B. 100 bis 300 Volt, über einen Radiofrequenz-Plasmagenerator 29 erzeugt und dabei auftretende Impedanz-Differenzen (Wechselstromwiderstände) in einer Matching Box 30 (bzw. Matching Unit) minimiert und angepasst. Die Sauerstoff-Moleküle werden bei 12, 06 eV und das Sauerstoff- Atom bei 13,62 eV ionisiert. Die Entladung der Sauerstoff- Moleküle erfolgt hauptsächlich durch direkte Elektronenstoß- Dissoziation und durch dissoziative Elektronenanlagerung. Als Zwischenprodukte entstehen unstabile angeregte O₂⁻*, die dann in atomaren Sauerstoff und Sauerstoff-Ionen zerfallen. Sauerstoffentladungen sind schwach negativ, das bedeutet, dass ein Bruchteil der negativen Ladung aus Ionen anstelle von Elektronen besteht. Die negativen Ionen sind O⁻, O₂⁻ und sogar O₃⁻ und bilden u.a. das Plasma 33. Diese negativen Sauerstoff-Ionen reagieren mit dem adsorbierten Ir-Precursor auf der Nafion-Oberfläche der Membran 22 unter Bildung von Iridiumdioxid den volatilen CO₂ und H₂O- Molekülen.

Nafion hat einen Schmelzpunkt von 200°C und die Ionenleitfähigkeit geht bei 100°C verloren. Da üblicherweise Iridiumdioxid bei 180 bis 200°C und Iridium bei 300 bis 400°C aus der Gasphase über einen Precursor physikalisch-chemisch über ein Atomlagenatomabscheidungsverfahren in sehr dünner Schicht (z.B. Nanometer-Bereich) abgeschieden werden, kann die chemische Umsetzung des Iridium-Precursor bei der Nafion-Membran nicht thermisch durch Erwärmen des Reaktionsraums und des Substrathalters 21 oder der Membran 22 direkt erfolgen. Beim Nafion findet die Schichtbildung bei Raumtemperatur über den Einsatz der Plasmaquelle statt. In dieser Plasmaquelle erhält das schichtbildende Gas über eine Entladung genügend viel Energie, um den an der Nafion-Oberfläche adsorbierten Iridium-Precursor in Irdiumdioxid zu überführen.

Damit bei einer Wasserelektrolyse als Anwendung an der Katalysator-Oberfläche gebildete H⁺-Ionen bei der Wasserspaltung durch die Nafion-Membran auf die Kathoden-Seite diffundieren können, sollte nicht die gesamte Nafion-Membran mit Iridiumdioxid bedeckt werden. Hierzu wird ein beispielhaftes Gitter 34 (alternativ eine Lochplatte) zwischen der Hohlkathode 32 und der Membran 22 vorgesehen, dass an einen Gleichspannungsgenerator 35 angeschlossen wird. Wie oben beschrieben wird das Gitter 34 an den negativen Pol des Gleichspannungsgenerators 35 angeschlossen, und eine gepulste Spannung überlagert, wodurch gezielt über die Löcher des Gitters 34 Iridiumdioxid erzeugt werden kann, und an den Stellen der Stege des Gitters 34 kein Iridiumdioxid erzeugt wird.

In einem vierten Schritt werden die abgespaltenen volatilen CO₂ und H₂O- Molekülen entfernt. Dazu werden der Reaktorraum und die beschichtete Nafion-Membran mit Stickstoff gespült, beispielsweise aus der Quelle für Trägergas 25.

Die zwei beschriebenen Abscheidungsprozesse und die beiden Spül-/Evakuierungsprozesse zwischen den Schicht-bildenden Schritten umfassen einen Abscheidezyklus, der mehrmals wiederholt wird. Jeder Einzelprozess läuft vollständig ab. Der Ir-Precursor und das Sauerstoffplasma werden sequenziell in die Reaktorkammer geleitet und auf die Nafion-Oberfläche solange chemisorbiert, bis die gesamte Nafion-Oberfläche belegt ist. Danach finden keine weiteren Adsorptionsvorgänge statt. Die Einwirkdauer der einzelnen Schritte wird so gewählt, dass in einer adäquaten Zeit die gerade eingeleitete Komponente mit der Nafion- Oberfläche reagiert und der überschüssige Dampf, sowie die Nebenprodukte aus dem Reaktorraum entfernt werden. Die Adsorptionszeit vom Ir-Precursor, die Spaltungszeit in IrO₂ und CO₂ sowie H₂O und die Spülzeiten zwischen den Schicht-bildenden Vorgängen liegen im Beispiel in der Größenordnung von Sekunden, können aber je nach Precursor-Material, Plasmagas, etc. variieren. Durch diese Art der Prozessführung begrenzen sich die Oberflächenreaktionen selbst, sodass eine reproduzierbare Iridiumdioxid-Schicht mit kalkulierbarer Zusammensetzung abgeschieden wird. Das abgeschiedene Iridiumdioxid wächst mit jedem nachfolgenden Zyklus.

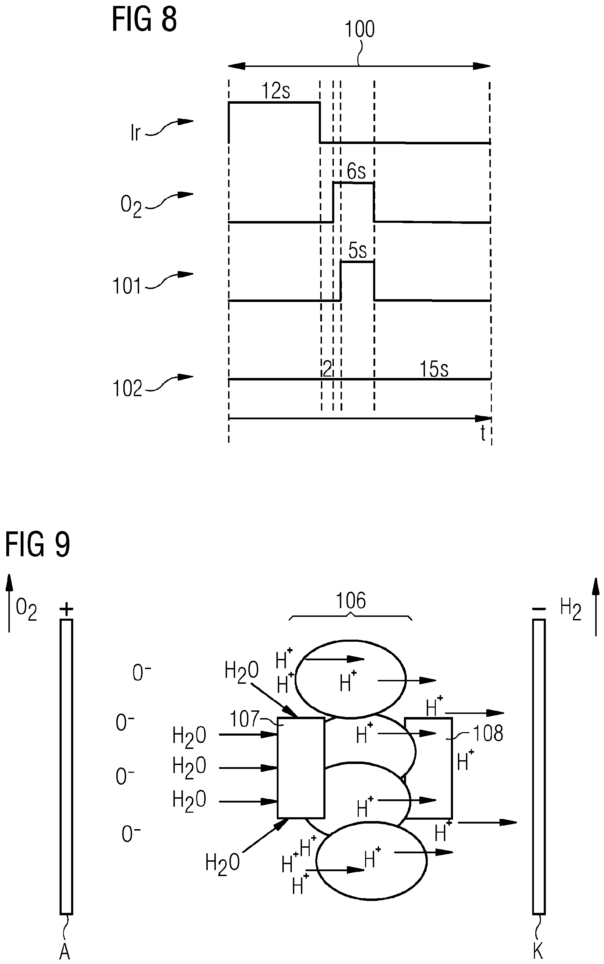

Figur 8 zeigt ein mögliches Muster der Taktzeiten für einen Abscheidungszyklus 100, mit der Abscheidung von Ir-Precursor für 12 Sekunden, einer 2 s Spülzeit 102, 6s Plasmaerzeugung (hier mit O₂) - mit den letzten 5 s mit RF-Erzeugung 101 bei 100 W, gefolgt wiederum von 15 s Spülzeit 102, hier beispielsweise mit N₂, oder auch mit Ar als Alternative. Gleichzeitig mit Beginn des Plasmaerzeugung wird auch der Gleichspannungs- oder der Mittelfrequenzgenerator gestartet, um eine Spannung zwischen maskierendem Gitter und Substrathalter aufrechtzuerhalten.

### Beispiel 2: Physikalisch chemische Abscheidung von Platin (HER- Katalysator)

Auf der Kathodenseite in einer Brennstoffzelle wird wegen der gewünschten Wasserstoff-Erzeugung üblicherweise ein HER- Katalysator benötigt. Ein HER-Katalysator ist zum Beispiel Platin. Platin lässt sich ebenfalls über Atomlagenabscheidung aus der Gasphase mit Hilfe eines Platin-Precursors auf der Nafion-Oberfläche mit dem erfindungsgemäßen Verfahren bilden, welches hier auf der zweiten Seite der beschichteten Membran aus Beispiel 1 abgeschieden werden kann, oder auch natürlich auf einer unbeschichteten Membran.

Für den Plasma-unterstützten Prozess wird MeCpPtMe₃ als Platin-Precursor verwendet. Da Nafion einen Schmelzpunkt von 200°C hat und die Ionenleitfähigkeit bei 100°C verloren geht, wird zur Abscheidung von Platin als metallischer Film bevorzugt MeCpPtMe₃ verwendet. Der Precursor Me Cp Pt Me₃ wird auf 31°C erhitzt. Die Abscheidung im Reaktor erfolgt bei 100°C, wie in Beispiel 1. Als zweiter Reaktand wird Sauerstoffplasma verwendet, wie in Beispiel 1, um die Methylgruppen und das Cyclopentadien abzuspalten. Auch wird wie in Beispiel 1 gespült, es kommt also die Vorrichtung aus Beispiel 1 zum Einsatz, außer dass die Quelle für Ir-Precursor 26 durch eine Quelle für den Pt-Precursor ersetzt wird. Die Taktzeiten für die einzelnen Schritte entsprechen denen des Beispiels 1, wobei anstelle der Ir-Abscheidung die Pt-Abscheidung tritt. Um eine Strukturierung der Platinschicht zu erhalten, wird auch bei der Platinabscheidung das maskierende Gitter 34 während der Plasmaerzeugung eingesetzt. Das Gitter befindet sich horizontal zwischen dem Substrathalter 21 und der Hohlkathoden-Plasmaquelle 31. Um die Beweglichkeit der O-Atome und O-Ionen auf die Nafion-Oberfläche zu erhöhen, wird zwischen maskierendem Gitter und Substrathalter wiederum ein pulsfähiger Gleichspannungsgenerator 35 und Mittelfrequenzgenerator angeschlossen.

In den beiden Beispielen erfolgt die Abscheidung des Katalysators aus der Dampfphase über einen Precursor und Schichtbildung durch Anwendung eines Plasmas. Hierdurch erfolgt eine Reduzierung der Katalysatormenge durch Herstellung von extrem dünnen Schichten im Nanometer-Bereich gegenüber der Tintenspritztechnik mit Schichtdicken von 10- 12 µm, da beispielsweise kommerziell erhältliche Iridiumdioxid- Pulver mit Partikelgrößen in Bereich einiger Mikrometer zur Herstellung einer Katalysatorschicht verwendet werden. Die Katalysatoren können mit dem Abscheidungsverfahren strukturiert aufgetragen werden. Das bedeutet, dass beispielsweise bei einer Wasserelektrolyse die bei der Wasserspaltung entstehenden Wasserstoff-Ionen an den nicht-beschichteten Stellen der Nafion-Oberfläche leicht durch die Membran auf die Kathodenseite transportiert werden können.

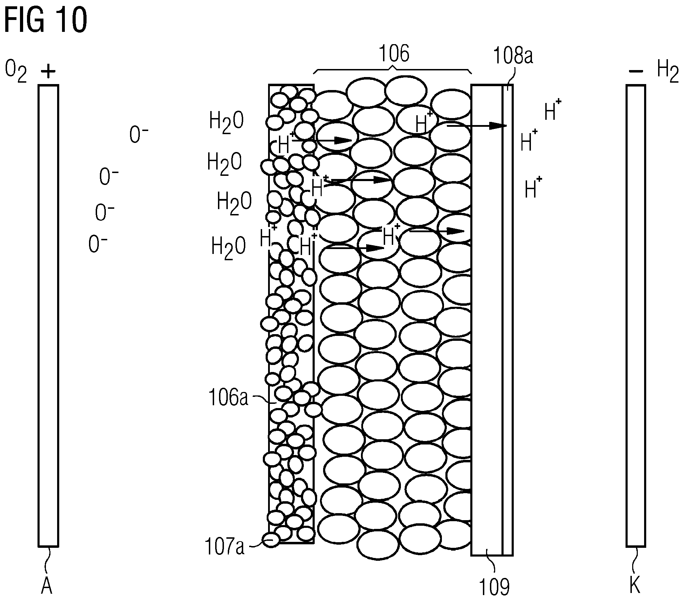

Figuren 9 und 10 stellen den geschilderten Sachverhalt schematisch dar.

Wie in Figur 9 gezeigt, gelangt in einer Elektrolysezelle mit der erfindungsgemäß hergestellten Membran Wasser, dass auf Seiten der Anode A eingebracht wird, zum strukturierten Iridimdioxidkatalysator 107 in Nanometer-Dicke auf der Nafion-Membran als Protonenaustauschmembran 106 , und die bei der Wasserspaltung entstehenden Protonen werden zum strukturierten Pt-Katalysator 108 auf Seiten der Kathode K geleitet.

Sind die katalytisch wirkenden Flächen auf der Protonenaustauschmembran 106 durch Tintenspritztechnik gemäß dem Stand der Technik hergestellt, wie in Figur 10 gezeigt, müssen sich die Wasserstoff-Ionen erst durch eine 10 bis 12 µm dicke Partikel-Polymerschicht mit Iridiumdioxid-Partikeln 107a und Bindemittel 106a, z.B. Nafion, quetschen, ehe die Ionen an die protonenleitenden Sulfonsäure-Gruppen der Protonenaustauschmembran 106 gelangen. Auch auf Seiten der Kathode K ergibt sich ein Widerstand durch eine Kohlenstoffschicht 109 als Bindemittel für die Platinschicht 108a.

Mit dem erfindungsgemäßen Verfahren kann auf der Membran im Vergleich zu bisherigen Beschichtungsverfahren eine große Menge an Metall eingespart werden. So sollte beispielsweise für Iridium ungefähr 99,3% gegenüber dem Tintenspritztechnik oder Decal- Verfahren bei gleich großer aktiver Fläche eingespart werden. Weiterhin erfolgt mit dem vorliegenden Verfahren eine Beschichtung der Membran, beispielsweise einer PEM, direkt mit dem Katalysator, und nicht unter Zuhilfenahme eines Bindemittels. Eine Reduzierung der Katalysatormenge erfolgt nicht durch Vergrößerung der aktiven Fläche, sondern durch die Art und Weise des Abscheidungsverfahrens.

Die mit dem Verfahren herstellbaren Schichtdicken des Katalysators im atomaren und Nanometerbereich ermöglichen Tunneleffekte und Hoppingmechanismen für die Elektronenleitung. Die Elektronen können schneller von einem lokalisierten Zustand in einem benachbarten springen, da die Abstände zwischen den Schichten kurz sind. Hierdurch kann eine weitere Effizienzsteigerung bei der Elektrolyse erreicht werden, wenn die erfindungsgemäß hergestellte Membran in einer Elektrolysezelle bzw. auch Elektrolysestack eingesetzt wird.

Ein weiterer Vorteil liegt darin, dass bei der Abscheidung des Metalls und/oder der Metallverbindung bzw. des Precursors mittels Atomlagenabscheidung das Einbringen von Verunreinigungen im Wesentlichen vermieden oder sogar vermieden werden kann, abgesehen von unvermeidbaren Verunreinigungen. So können beispielsweise bei der Synthese von Iridium oder Iridiumdioxid und Platin mittels Atomlagenabscheidung Verunreinigung von anorganischen Anionen wie Chlorid, Reduktionsmitteln und/oder Tensiden verringert oder sogar verhindert werden oder aufgrund der Precursoren wie Iridiumchlorid oder Platinchlorid.

Durch die zielgerichtete Abscheidung können zudem größere Partikelanhäufungen und Agglomerate vermieden werden, da die Katalysatoren als zusammenhängende Schicht auf die Membran abgeschieden werden und nicht über eine Tinte als Partikel in Form von Pulver. Ein Ablösen von einzelnen Katalysator-Partikeln von der Membran wird größtenteils unterbunden oder ist nicht möglich, da der Katalysator auf der Membran als zusammenhängende Schicht abgeschieden wird im Gegensatz zu einer Tintenspritztechnik oder ähnlichen Verfahren.

Durch die Vermeidung des Einsatzes eines polymeren Bindemittels, wie beispielsweise in Tinten, treten zudem keine Vergiftungserscheinungen am Katalysator auf, beispielsweise durch Polymer. Dagegen können die Katalysatoren bei der Tintenspritztechnik, mit z.B. Iridiumdioxid-Partikeln in einer Nafion- Lösung dispergiert, durch das Bindemittel vergiftet werden. Nafion als Bindemittel besteht im Wesentlichen aus einem Fluor- Kohlenstoffgerüst mit CF₂-Seitenketten. Die Fluoratome sind nach außen elektronegativ durch freie Elektronenpaare geladen. Diese freien Elektronenpaare können an die positiven Zentren (Elektronenlücken) des Katalysators andocken. Damit steht der Katalysator für weitere chemische Umsetzungen und Bildung von Zwischenstufen nicht mehr zur Verfügung. Der Katalysator ist vergiftet und die Katalysatoraktivität wird eingeschränkt.

Werden Katalysatormetalle, z.B. die hier beispielhaften Ir- oder Pt-basierten Aktivkomponenten, aus der Gasphase über entsprechende Precursoren auf die Membran abgeschieden, können größere Partikelanhäufungen und Agglomerate vermieden werden. Damit sind die Katalysatoren sowohl auf der Anodenelektrode als auf der Kathodenseite einer Elektrolysezelle, z.B. einer PEM-Elektrolysezelle, sehr gut verteilt. Durch eine gute Verteilung wird die Anzahl der aktiven Zentren im Katalysator deutlich erhöht gegenüber einer Partikelanhäufung. Die Massenaktivität an Katalysator, z.B. Iridium und Platin, wird gesteigert, da Iridium und Platin optimaler eingesetzt werden. Damit kann Katalysator, z.B. Iridium und Platin, eingespart werden.

Das plasmaunterstützte ALD-Verfahren begünstigt zudem aufgrund seiner physikalischen und chemischen Vorgehensweise sehr dünne und homogene Beschichtungen mit gewünschter Stöchiometrie. Im Gegensatz zur Tintentechnik werden die Katalysatoren zudem als glatte Schichten abgeschieden, so dass in Elektrolysezellen gebildete Gasblasen, z.B. Wasserstoff- oder Sauerstoffblasen in PEM-Elektrolysezellen, aber beispielsweise auch andere Gase in anderen Elektrolysezellen, an den glatten Flächen leicht abperlen können. Bei der Tintenspritztechnik liegen die Partikel häufig auch als Agglomerate vor. Diese Agglomerate zeigen Ecken und hervorstehende Kanten und bilden eine raue Partikeloberfläche. An diesen Flächen bleiben die Gasblasen wie Wasserstoff- und Sauerstoffblasen besonders gut haften und bei herrschenden Spannungen von 2 bis 3 Volt können an den Anhaftungsstellen die Katalysatoren erodiert werden. Das bedeutet Verbrauch an teurem Katalysatormaterial und Einschränkung der Katalysatoraktivität.

Durch die Atomlagenabscheidung können die elektrochemisch aktiven Materialien zudem nahtlos aneinandergefügt werden, so dass kaum ein Innenwiderstand zwischen den Materialien herrscht und der Ladungstransport ohne Hindernisse erfolgen kann. Beim ALD- Verfahren begrenzen sich die Oberflächenreaktionen durch die Art der Prozessführung selbst, so dass die aktiven Materialien in Schichtdicke und Zusammensetzung kalkulierbar und reproduzierbar abgeschieden werden.

Es ergibt sich in Summe eine Senkung der Katalysator-Beladung (z.B. Iridiumdioxid und Platin) durch Bildung einer sehr dünnen und glatten Schicht mit einer Dicke im Nanobereich direkt auf der Membran, z.B. einer Protonenaustauschmembran, mit z.B. einer Einsparung von ungefähr 99,3% Iridium zum herkömmlichen Verfahren. Es erfolgt eine Reduktion des Gewichtseinsatzes der teuren Katalysatoren, z.B. Iridium und Platin, sowie eine Verbesserung der elektrokatalytischen Effizienz, damit eine Senkung der Betriebskosten und Investitionskosten bei Elektrolysezellen. Es ergibt sich eine Erhöhung der elektrochemischen Stabilität des Katalysators, da keine bis sehr wenig Erosion durch die glatten Katalysatorschichten erfolgt, und entsprechend eine Verlängerung der Lebensdauer von Katalysatoren. Hierdurch lassen sich Elektrolysezellen auch mit teuren Katalysatoren in den Mega- und Gigawatt-Bereich skalieren und somit auch der Prozess großtechnisch wirtschaftlich umsetzen. Die Abhängigkeit von limitierten Metall-Ressourcen, z.B. Iridium, wird entschärft.

### Bezugszeichenliste

- 1: Bereitstellen einer Membran in einem Reaktorraum
- 2: Beschichten der Membran auf mindestens einer ersten Oberfläche mit mindestens einem Metall und/oder mindestens einer Metallverbindung durch Atomlagenabscheidung
- 3: Spülen des Reaktorraums derart, dass im Reaktorraum verbleibendes und nicht auf der mindestens einen Oberfläche der Membran abgeschiedenes Metall und/oder im Reaktorraum verbleibende und nicht auf der mindestens einen Oberfläche der Membran abgeschiedene Metallverbindung aus dem Reaktorraum entfernt wird
- 4: Erzeugen eines Plasmas mittels einer Plasmaquelle innerhalb des Reaktorraums und in Kontakt bringen des Plasmas mit dem mindestens einen auf der mindestens einen Oberfläche der Membran abgeschiedenen Metall und/oder der mindestens einen auf der mindestens einen Oberfläche der Membran abgeschiedenen Metallverbindung, wobei das Plasma mit dem mindestens einen Metall und/oder der mindestens einen Metallverbindung reagiert
- 5: Spülen des Reaktorraums derart, dass im Schritt d) bei der Reaktion erzeugte volatile Verbindungen entfernt werden
- 6: Membran
- 7: erster Katalysator
- 8: zweiter Katalysator
- 9: austauschbare weitere Membran
- 10: Bipolarplatte
- 11: Endplatte
- 12: Gasdiffusionsschicht

- 20: Reaktor
- 21: Substrathalter
- 22: Membran
- 23: Ventil
- 24: Vakuumpumpe
- 25: Quelle für Trägergas
- 26: Quelle für Ir-Precursor
- 26a: Massenflussregler
- 27: Quelle für Plasmagas
- 28: zweiter Massenflussregler
- 29: Radiofrequenz-Plasmagenerator
- 30: Matching Box
- 31: Hohlkathoden-Plasmaquelle
- 32: Hohlkathode
- 33: Plasma
- 34: Gitter
- 35: Gleichspannungsgenerator

- 100: Abscheidungszyklus
- 101: RF-Erzeugung
- 102: Spülzeit

- 106: Protonenaustauschmembran
- 106a: Bindemittel
- 107: strukturierter Iridiumdioxidkatalysator
- 107a: Iridiumdioxid-Partikel
- 108: strukturierter Pt-Katalysator
- 108a: Platinschicht
- 109: Kohlenstoffschicht

- A: Anode
- K: Kathode

## Patentansprüche

1. Verfahren zum Beschichten einer Membran mit einem Katalysator, umfassend
a) Bereitstellen einer Membran in einem Reaktorraum;
b) Beschichten der Membran auf mindestens einer ersten Oberfläche mit mindestens einem Metall und/oder mindestens einer Metallverbindung durch Atomlagenabscheidung, wobei das mindestens eine Metall und/oder die mindestens eine Metallverbindung in den Reaktorraum geleitet und mittels Atomlagenabscheidung auf der mindestens einen Oberfläche der Membran beschichtet wird;
c) Spülen des Reaktorraums derart, dass im Reaktorraum verbleibendes und nicht auf der mindestens einen Oberfläche der Membran abgeschiedenes Metall und/oder im Reaktorraum verbleibende und nicht auf der mindestens einen Oberfläche der Membran abgeschiedene Metallverbindung aus dem Reaktorraum entfernt wird;
d) Erzeugen eines Plasmas mittels einer Plasmaquelle innerhalb des Reaktorraums und in Kontakt bringen des Plasmas mit dem mindestens einen auf der mindestens einen Oberfläche der Membran abgeschiedenen Metall und/oder der mindestens einen auf der mindestens einen Oberfläche der Membran abgeschiedenen Metallverbindung, wobei das Plasma mit dem mindestens einen Metall und/oder der mindestens einen Metallverbindung reagiert; und
e) Spülen des Reaktorraums derart, dass im Schritt d) bei der Reaktion erzeugte volatile Verbindungen entfernt werden.

2. Verfahren nach Patentanspruch 1, wobei die Membran eine Polymeraustausch-Membran ist.

3. Verfahren nach Patentanspruch 1 oder 2, wobei das mindestens eine Metall oder die mindestens eine Metallverbindung ein Metall umfasst, das ausgewählt ist aus der Gruppe, bestehend aus Ru, Rh, Pd, Ag, Os, Ir, Pt, Au.

4. Verfahren nach einem der vorgehenden Patentansprüche, wobei in Schritt d) die Plasmaerzeugung mit einem Gas umfassend Sauerstoff erfolgt, wobei bei der Reaktion eine Sauerstoffverbindung des mindestens einen Metalls und/oder der mindestens einen Metallverbindung hergestellt wird.

5. Verfahren nach einem der vorgehenden Patentansprüche, wobei der Schritt b) bei einer Temperatur von weniger als 300°C, bevorzugt von weniger als 100°C erfolgt.

6. Verfahren nach einem der vorgehenden Patentansprüche, wobei im Schritt b) des Beschichtens das mindestens eine Metall und/oder die mindestens eine Metallverbindung und/oder ein Vorläufer des mindestens einen Metalls mittels eines inerten Trägergases in den Reaktorraum geleitet wird.

7. Verfahren nach einem der vorgehenden Patentansprüche, wobei das Plasma in Schritt d) mittels einer Hohlkathoden-Plasmaquelle erzeugt wird.

8. Verfahren nach einem der vorgehenden Patentansprüche, wobei in Schritt d) zwischen der Plasmaquelle und der beschichteten Membran ein Gitter oder eine Lochplatte angeordnet ist, wobei an einen Substrathalter, auf dem die Membran befestigt ist, und dem Gitter oder der Lochplatte ein Gleichspannungsgenerator angeschlossen ist, wobei das Gitter oder die Lochplatte an einem negativen Pol des Gleichspannungsgenerators angeschlossen wird.

9. Verfahren nach Patentanspruch 8, wobei während des Schritts d) an den Gleichspannungsgenerator über eine Grundspannung eine überlagerte Pulsspannung angelegt wird, derart, dass an dem Gitter oder der Lochplatte wechselnd eine positive und eine negative Spannung anliegt.

10. Verfahren nach Patentanspruch 9, wobei die überlagerte Spannung eine Pulsfrequenz von 0,5 bis 30 kHz, bevorzugt 1 bis 25 KHz aufweist.

11. Verfahren nach einem der vorgehenden Patentansprüche, wobei die Schritte b) bis e) mehrfach hintereinander durchgeführt werden.

12. Beschichtete Membran, hergestellt durch ein Verfahren gemäß einem der vorgehenden Patentansprüche.

13. Elektrolysezelle, umfassend eine beschichtete Membran nach Patentanspruch 12.

14. Verwendung einer beschichteten Membran nach Patentanspruch 12 in einer Elektrolysezelle, bevorzugt in einer PEM Elektrolyse, bei der die Membran eine Polymer-Elektrolyt-Membran (PEM) ist.

15. Vorrichtung zur Beschichtung einer Membran, umfassend:
- einen Reaktor umfassend einen Reaktorraum;
- einen Substrathalter im Reaktorraum, der dazu ausgebildet ist, eine Membran zu halten;
- eine Plasmaquelle, die innerhalb des Reaktorraums angeordnet und dazu ausgebildet ist, aus einem Reaktionsgas ein Plasma zumindest in Teilen innerhalb des Reaktorraums zu erzeugen;
- eine erste Zuführeinrichtung für mindestens ein Metall und/oder mindestens eine Metallverbindung, die dazu ausgebildet ist, dem Reaktorraum mindestens ein Metall und/oder mindestens eine Metallverbindung zuzuführen;
- eine zweite Zuführeinrichtung für das Reaktionsgas, die dazu ausgebildet ist, das Reaktionsgas dem Reaktorraum derart zuzuführen, dass mit der Plasmaquelle aus dem Reaktionsgas ein Plasma erzeugt werden kann; und
- mindestens eine dritte Zuführeinrichtung für ein Spülgas, die dazu ausgebildet ist, dem Reaktorraum mindestens ein Spülgas zuzuführen, wobei die mindestens eine zweite Zuführeinrichtung auch teilweise mit der ersten und/oder zweiten Zuführeinrichtung kombiniert sein kann.
